# EUROPÄISCHE PATENTANMELDUNG

(11) **EP 3 699 016 A1**
(43) Veröffentlichungstag der Anmeldung: **26.08.2020**
(21) Anmeldenummer: 20157095.9
(22) Anmeldetag: 13.02.2020
(51) Int. Cl.: B60L 15/00, B60L 15/08, H02M 7/493, H02J 1/02

(54) **VERFAHREN ZUM BETRIEB VON WENIGSTENS ZWEI MIT EINEM GLEICHSTROMNETZWERK VERBUNDENEN PULSWECHSELRICHTERN, SCHALTUNGSANORDNUNG UND KRAFTFAHRZEUG**

(30) Priorität: 21.02.2019 DE 102019202335
(71) Anmelder: Audi AG, 85045 Ingolstadt (DE)
(72) Erfinder: Schiedermeier, Maximilian, 85049 Ingolstadt (DE); Rettner, Cornelius, 91052 Erlangen (DE)

(57) **Zusammenfassung**

Verfahren zum Betrieb von wenigstens zwei mit einem Gleichstrom-netzwerk (5) verbundenen Pulswechselrichtern (3, 4), wobei die Puls-wechselrichter (3, 4) jeweils über ein Ansteuersignal angesteuert und in jeweils einem Arbeitspunkt betrieben werden, wobei in Abhängigkeit einer die Arbeitspunkte der Pulswechselrichter (3, 4) beschreibenden Arbeitspunktinformation eine Phasendifferenz zwischen den Ansteuersignalen der wenigstens zwei Pulswechselrichter (3, 4) durch Anpassung des Ansteuersignals wenigstens eines der Pulswechselrichter (3, 4) erzeugt wird.

## Beschreibung

Die Erfindung betrifft ein Verfahren zum Betrieb von wenigstens zwei mit einem Gleichstromnetzwerk verbundenen Pulswechselrichtern, wobei die Pulswechselrichter jeweils über ein Ansteuersignal angesteuert und in jeweils einem Arbeitspunkt betrieben werden. Weiterhin betrifft die Erfindung eine Schaltungsanordnung sowie ein Kraftfahrzeug.

Pulswechselrichter dienen dazu, eine Gleichspannung in eine Wechselspannung oder eine Wechselspannung in eine Gleichspannung umzurichten. Sie können beispielsweise dazu verwendet werden, um Elektromotoren über eine Gleichspannungsquelle wie eine Batterie zu betreiben. Bei den Elektromotoren kann es sich beispielsweise um elektrische Traktionsmotoren von Kraftfahrzeugen, beispielsweise von batterieelektrischen Fahrzeugen oder von Plug-in-Hybridfahrzeugen, handeln. Bei diesen Fahrzeugen wird wenigstens ein Traktionselektromotor über eine Batterie des Kraftfahrzeuges betrieben, um ein rein elektrisches Fahren des Kraftfahrzeuges zumindest zeitweise zu ermöglichen. Die Fahrzeuge können dabei mehrere über eine gemeinsame Batterie betreibbare Traktionsmotoren, welche jeweils dem Antrieb einer Achse oder eines Rades des Kraftfahrzeuges dienen, aufweisen.

In einem Bordnetz eines Kraftfahrzeugs, welches eine Gleichspannungsquelle umfasst aus der zwei oder mehr Pulswechselrichter gemeinsam gespeist werden, kann es in unerwünschter Weise zu einer Überlagerung von durch die jeweiligen Schaltvorgänge der Pulswechselrichter erzeugten Störungen kommen. Insbesondere bei einer konstruktiven Überlagerung, beispielsweise von als Stromrippel oder Spannungsrippel ausgeprägten Störungen, können in dem Bordnetz gleichspannungsseitige Störpegel auftreten. Dies ist nachteilig, da weitere, an der Gleichspannungsseite mit den Pulswechselrichtern verbundene Komponenten an ein derartiges Auftreten von Störungen angepasst bzw. auf die möglicherweise auftretenden Störpegel ausgelegt sein müssen. Insbesondere müssen zur Filterung bzw. Glättung der auftretenden Störungen eingesetzte Kondensatoren der Gleichspannungsseite an die Störpegel angepasst sein und dazu eine ausreichende Kapazität bzw. eine ausreichende Baugröße aufweisen. Aus dem Stand der Technik sind verschiedene Möglichkeiten zum Betrieb von über ein gemeinsames Gleichspannungsnetz verbundenen Pulswechselrichtern bekannt.

In JP 2012 120296 A wird ein Antriebssteuerungssystem beschrieben, welches zwei über eine gemeinsame Gleichstromversorgung betriebene und jeweils mit einem Elektromotor verbundene Pulswechselrichter umfasst. Um den durch den Betrieb der Wechselrichter im Gleichspannungsnetz auftretenden Stromrippel zu reduzieren, werden die Pulswechselrichter bei gleichzeitigem Betrieb der Elektromotoren mit derselben Taktfrequenz betrieben, wobei zwischen den Taktsignalen ein fester Phasenversatz von einem Viertel einer Taktlänge eingestellt wird.

US 5,142,468 A beschreibt eine Schaltungsanordnung zum Betrieb zweier Elektromotoren, welche zum Antrieb eines gepanzerten Fahrzeugs verwendet werden. Die Elektromotoren werden dabei jeweils über einen Inverter angesteuert. Um neben den Motoren auch eine weitere Last mit Energie zu versorgen, können die Inverter mit einem Phasenversatz von 180° betrieben werden, um eine Schaltungsanordnung zur Pulsformung als Last zu betreiben. Wenn die Schaltungsanaordnung zur Pulsformung keine Energie benötigt, so werden die Inverter ohne Phasenversatz zueinander betrieben.

In EP 2 541 755 A1 wird eine Antriebsvorrichtung für ein Fahrzeug beschrieben. Dabei wird ein als Doppelsternmotor aufgebauter elektrischer Antrieb verwendet, welcher im normalen Fahrbetrieb über zwei parallel geschaltete Pulswechselrichter und miteinander gekoppelte Sternwicklungen betrieben wird. Bei einem Generatorbetrieb werden die beiden Pulswechselrichter voneinander getrennt und die zwei Zwischenkreise werden in Serie geschaltet, so dass die Gesamtspannung des Zwischenkreises das Doppelte eines Einzelzwischenkreises beträgt.

Der Erfindung liegt die Aufgabe zugrunde, ein, insbesondere hinsichtlich des Auftretens von Störungen in einem Gleichstromnetzwerk, verbessertes Verfahren zum Betrieb von wenigstens zwei mit dem Gleichstromnetzwerk verbundenen Pulswechselrichter anzugeben.

Zur Lösung dieser Aufgabe ist bei einem Verfahren der eingangs genannten Art erfindungsgemäß vorgesehen, dass in Abhängigkeit einer die Arbeitspunkte der Pulswechselrichter beschreibenden Arbeitspunktinformation eine Phasendifferenz zwischen den Ansteuersignalen der wenigstens zwei Pulswechselrichter durch Anpassung des Ansteuersignals wenigstens eines der Pulswechselrichter erzeugt wird.

Das erfindungsgemäße Verfahren bietet dabei den Vorteil, dass eine Entstehung von Störungen aufgrund einer ungünstigen bzw. ungeregelten oder unkontrollierten Phasenbeziehung zwischen den Taktungen der Pulswechselrichtung vermieden werden kann. Durch Ausbildung einer an die aktuellen Arbeitspunkte der Pulswechselrichter angepassten Phasendifferenz zwischen den Ansteuersignalen können insbesondere im Gleichstromnetzwerk auftretende Störungen reduziert werden. Das erfindungsgemäße Verfahren bietet dabei den Vorteil, dass die arbeitspunktabhängige Phasendifferenz sowohl bei mit derselben Taktfrequenz betriebenen Pulswechselrichtern als auch bei mit unterschiedlichen Taktfrequenzen betriebenen Pulswechselrichtern eingesetzt werden kann. Vorteilhaft können durch das Einstellen der Phasendifferenz auch Störungen reduziert oder beseitigt werden, welche sich nicht aus der Taktfrequenz der Pulswechselrichter an sich, sondern beispielsweise durch eine zweite oder eine weitere Harmonische, also einem Vielfachen der Taktfrequenz, ergeben. Die Ursache einer Störung oder die Ursache einer größten Störung kann sich je nach den aktuell vorherrschenden Arbeitspunkten der wenigstens zwei Pulswechselrichter unterscheiden, so dass für unterschiedliche Kombinationen aus Arbeitspunkten der wenigstens zwei Pulswechselrichter durch jeweils eine andere Phasendifferenz die bestmögliche Störunterdrückung im Gleichstromnetzwerk ergeben kann. Durch die Arbeitspunktinformation werden die jeweiligen Arbeitspunkte der wenigstens zwei Pulswechselrichter beschrieben, so dass die Phasendifferenz anhand der Arbeitspunktinformation bestimmt werden kann.

Ein weiterer Vorteil des erfindungsgemäßen Verfahrens ist, dass durch die reduzierten Störamplituden die Belastung von weiteren im Gleichstromnetzwerk vorhandenen Komponenten reduziert wird. Die wenigstens zwei Pulswechselrichter können insbesondere parallel zueinander in dem Gleichstromnetzwerk geschaltet sein. Weiterhin können zur Reduktion der Welligkeit im Gleichstromnetzwerk eingesetzte, insbesondere parallel zu den Gleichrichtern geschaltete, Kondensatoren kleiner, das heißt mit einer geringeren Kapazität, ausgeführt werden. Eine geringere Kapazität eines Kondensators hat in der Regel eine geringe Baugröße des Kondensators sowie verminderte Bauteilkosten zur Folgen, so dass sich mit dem erfindungsgemäßen Verfahren betriebene Schaltungsanordnungen platzsparender und günstiger realisieren lassen.

Insbesondere bei Pulswechselrichtern, welche zum Antrieb von Traktionsmotoren eines Elektrofahrzeugs eingesetzt werden, können sich verschiedene, sich bei einem Fahrbetrieb des Elektrofahrzeugs fortlaufend ändernde Arbeitspunkte der jeweiligen Pulswechselrichter ergeben. Die Arbeitspunkte können sich dabei durch den Fahrzustand des Kraftfahrzeugs ergeben, welcher zumindest teilweise von den mit den Pulswechselrichtern verbundenen Traktionselektromotoren erzeugt wird. Dabei können sich die Arbeitspunkte der wenigstens zwei Pulswechselrichter insbesondere unterscheiden. Da die zum Betrieb der Traktionselektromotoren eingesetzten Pulswechselrichter in der Regel parallel an ein eine Hochvoltbatterie und/oder ein Brennstoffzellensystem des Kraftfahrzeuges umfassendes Gleichstromnetzwerk angeschlossen sind, können sich durch die arbeitspunktabhängigen und somit unterschiedlichen Schaltvorgänge der Pulswechselrichter Störungen in dem die Gleichstromnetzwerk ergeben. Das Einstellen der Phasendifferenz kann dabei in einem Generatorbetrieb und/oder in einem Motorbetrieb der Traktionselektromotoren eingesetzt werden.

Die Phasendifferenz wird durch Anpassung des Ansteuersignals wenigstens eines der Pulswechselrichter erzeugt. Auch bei mehr als zwei Pulswechselrichtern kann die Phasendifferenz durch Anpassung eines oder mehrerer Steuersignale der Pulswechselrichter erzeugt werden, wobei die Phasendifferenz in diesem Fall zwischen verschiedenen Paaren der mehr als zwei Pulswechselrichter unterschiedlich ausfallen kann.

Bei sich fortlaufend ändernden Arbeitspunkten kann eine fortlaufend aktualisierte Arbeitspunktinformation verwendet werden, welche es ermöglicht nach einer Arbeitspunktänderung und/oder nach einer gewissen Zeitspanne eine erneute Ermittlung einer Phasendifferenz vorzunehmen und eine an die aktuellen Arbeitspunkte der wenigstens zwei Pulswechselrichter angepasste Phasendifferenz einzustellen.

Erfindungsgemäß kann vorgesehen sein, dass die Phasendifferenz derart eingestellt wird, dass ein in dem Gleichstromnetzwerk auftretender Wechselstrom und/oder eine in dem Gleichstromnetzwerk auftretende Wechselspannung minimiert wird. Durch die Minimierung des Wechselstroms bzw. der Wechselspannung kann die Amplitude des Wechselstroms bzw. der Wechselspannung verringert und/oder das Auftreten des Wechselstroms bzw. der Wechselspannung komplett unterbunden werden.

Erfindungsgemäß kann vorgesehen sein, dass ein Wert der Phasendifferenz in Abhängigkeit einer Messgröße des Gleichstromnetzwerks, insbesondere eines im Gleichstromnetzwerk gemessenen Stromes und/oder einer im Gleichstromnetzwerk gemessenen Spannung, und/oder anhand einer hinterlegten Zuordnungsvorschrift ermittelt wird. Durch die Ermittlung eines Werts der Phasendifferenz in Abhängigkeit einer Messgröße des Gleichstromnetzwerks kann eine arbeitspunktabhängige Regelung der Phasendifferenz erreicht werden. Bei der Verwendung einer hinterlegten Zuordnungsvorschrift, welche bestimmten Kombinationen der Arbeitspunkte der wenigstens zwei Pulswechselrichter einen bestimmten Wert der Phasendifferenz zuordnet, kann eine Steuerung der arbeitspunktabhängigen Phasendifferenz realisiert werden. Auch eine Kombination aus einer Abhängigkeit von einer Messgröße des Gleichstromnetzwerks und einer hinterlegten Zuordnungsvorschrift ist denkbar.

Für die Arbeitspunktinformation kann erfindungsgemäß vorgesehen sein, dass sie in Abhängigkeit von durch die Pulswechselrichter jeweils erzeugten Wechselströmen, insbesondere von durch die Pulswechselrichter jeweils erzeugten Phasenströmen, ermittelt wird. Die Ermittlung der Arbeitspunkte aus den durch die Pulswechselrichter jeweils erzeugten Wechselströmen oder den jeweils durch sie erzeugten Phasenströmen hat den Vorteil, dass in vielen Anwendungsfällen die Wechselströme bzw. die Phasenströme zur Regelung des Betriebs der Pulswechselrichter in ihrem jeweiligen Arbeitspunkt bereits gemessen werden, so dass die entsprechenden Messwerte bereits vorliegen. Der in einem der Pulswechselrichter eingestellte Arbeitspunkt kann durch den von dem Pulswechselrichter erzeugten Wechselstrom bzw. die von dem Pulswechselrichter jeweils erzeugten Phasenströme bestimmt werden. Dazu kann die Arbeitspunktinformation beispielsweise in Abhängigkeit einer Amplitude des Wechselstroms, einer Frequenz des Wechselstroms und/oder eines zeitlichen Verlaufs des Wechselstroms ermittelt werden. Entsprechend kann die Arbeitspunktinformation auch in Abhängigkeit der Amplitude der jeweiligen Phasenströme, ihrer jeweiligen zeitlichen Dauer und/oder ihres jeweiligen zeitlichen Verlauf ermittelt werden.

Zusätzlich oder alternativ dazu kann erfindungsgemäß vorgesehen sein, dass die Arbeitspunktinformation in Abhängigkeit wenigstens einer Messgröße des Gleichstromnetzwerks, insbesondere eines Gleichstromes und/oder einer Gleichspannung im Gleichstromnetzwerk, ermittelt wird. Auch die Messgröße des Gleichstromnetzwerks, wie ein Gleichstrom und/oder eine Gleichspannung des Gleichstromnetzwerks, können Aufschluss über den aktuellen Arbeitspunkt eines Pulswechselrichters liefern. Beispielsweise kann aus der Messgröße des Gleichstromnetzwerks bestimmt werden, ob sich mit den wenigstens zwei Pulswechselrichtern betriebene elektrische Maschinen in einem Motorbetrieb oder einem Generatorbetrieb befinden.

In einer bevorzugten Ausgestaltung der Erfindung kann vorgesehen sein, dass die Pulswechselrichter jeweils mit einer elektrischen Maschine verbunden sind, wobei die Arbeitspunktinformation in Abhängigkeit von durch die jeweiligen elektrischen Maschinen zu erzeugenden Sollmomenten und/oder von durch die jeweiligen elektrischen Maschinen zu erzeugenden Solldrehzahlen und/oder von jeweils eine Lage eines Rotors der jeweiligen elektrischen Maschine beschreibenden Rotorlageinformationen ermittelt wird.

Durch die jeweiligen elektrischen Maschinen zu erzeugende Sollmomente und/oder durch die jeweiligen elektrischen Maschinen zu erzeugende Solldrehzahlen können beispielsweise in einem Kraftfahrzeug von einer Motorsteuereinheit vorgegeben werden, wobei die wenigstens zwei Pulswechselrichter über ihr Ansteuersignal derart angesteuert werden, dass sich der dem jeweils geforderten Sollmoment bzw. der der jeweils geforderten Drehzahl entsprechende Arbeitspunkt des Pulswechselrichters einstellt. Zur Ermittlung der Arbeitspunktinformation ist es auch möglich, dass Rotorlageinformationen, welche jeweils eine Lage eines Rotors der jeweiligen elektrischen Maschine beschreiben, berücksichtigt werden. Eine Rotorlageinformation kann beispielsweise über einen Sensor der elektrischen Maschine bereitgestellt werden, welcher die aktuelle Rotorlage, das heißt die aktuelle Ausrichtung des Rotors der elektrischen Maschine zu einem Stator der elektrischen Maschine, erfasst.

Erfindungsgemäß kann vorgesehen sein, dass der wenigstens eine Pulswechselrichter zur Ausbildung der Phasendifferenz derart angesteuert wird, dass wenigstens eine Periode seiner Taktung verlängert oder verkürzt wird. Es ist zum Einstellen einer Phasendifferenz zwischen den wenigstens zwei Pulswechselrichtern ausreichend, wenn bei wenigstens einem Pulswechselrichter eine Periode seiner Taktung verlängert oder verkürzt wird. Gegenüber einem oder mehrerer mit unveränderter Taktung weiter betriebenen Pulswechselrichtern ergibt sich somit eine Phasendifferenz, welche durch das Ausmaß der Verkürzung bzw. der Verlängerung der wenigstens einen Periode der Taktung einstellbar ist. Die Änderung wenigstens einer Periode der Taktung kann auch als eine zeitlich begrenzte Änderung der Taktfrequenz der Taktung des Pulswechselrichters aufgefasst werden. Bei mehreren Pulswechselrichtern, welche mit unterschiedlichen Taktfrequenzen betrieben werden, ändert sich die eingestellte Phasendifferenz fortlaufend aufgrund des Frequenzunterschiedes der Taktfrequenzen. In einem solchen Fall kann vorgesehen sein, dass nach Ablauf einer beispielsweise von der Frequenzdifferenz abhängigen Zeitspanne erneut eine von den dann aktuellen Arbeitspunkten abhängige Phasendifferenz eingestellt wird. Es ist auch möglich, dass bei mehreren oder allen der wenigstens zwei mit dem Gleichstromnetzwerk verbundenen Pulswechselrichtern jeweils eine Periode ihrer Taktung verlängert oder verkürzt wird, um die gewünschte Phasendifferenz zwischen den jeweiligen Pulswechselrichtern einzustellen.

Erfindungsgemäß kann vorgesehen sein, dass zur Ausbildung der Phasendifferenz einer der Pulswechselrichter unverändert weiterbetrieben wird, wobei der oder die weiteren Pulswechselrichter zur Ausbildung der Phasendifferenz angesteuert werden, oder dass alle Pulswechselrichter zur Ausbildung der Phasendifferenz angesteuert werden. Auf diese Weise kann vorteilhaft auch bei drei oder mehr Pulswechselrichtern in einfacher Weise eine Phasendifferenz zwischen den einzelnen Pulswechselrichtern eingestellt werden. Ein Pulswechselrichter wird unverändert weiterbetrieben und kann in diesem Zusammenhang auch als Master bezeichnet werden. Die weiteren Pulswechselrichter, welche bezogen auf den Master eine Phasendifferenz aufweisen sollen, werden beispielsweise derart angesteuert, dass wenigstens eine Periode ihrer Taktung verlängert oder verkürzt wird. Es ist möglich, dass die weiteren Pulswechselrichter, welche auch als Slave bezeichnet werden können, derart angesteuert werden, dass sie nicht nur in Bezug zu dem Master eine Phasendifferenz aufweisen, sondern auch untereinander. Dies kann entsprechend durch die Wahl der Verlängerung wenigstens einer Periode der Taktung bzw. der Verkürzung wenigstens einer Periode der Taktung eines jeweiligen Slave-Pulswechselrichters erzeugt werden.

Erfindungsgemäß kann vorgesehen sein, dass jedem Pulswechselrichter ein Treiber zugeordnet ist, durch welchen der Pulswechselrichter mit dem Ansteuersignal angesteuert wird, wobei wenigstens einer der Treiber durch einen die Arbeitspunktinformation auswertenden Phasenregler zur Ausbildung der Phasendifferenz angesteuert wird. Die beispielsweise durch eine Verlängerung oder Verkürzung einer Periode der Taktung erzeugte Phasendifferenz kann durch eine Anpassung des Ansteuersignals, mit welchem der Pulswechselrichter durch den Treiber angesteuert wird, erzeugt werden.

Über den die Arbeitspunktinformation auswertenden Phasenregler kann die arbeitspunktabhängige Phasendifferenz bestimmt werden und durch Ansteuerung wenigstens eines der Treiber eingestellt werden. Der Phasenregler kann dabei als Steuergerät oder als Teil eines Steuergerätes realisiert sein und zur Bestimmung der Arbeitspunktinformation insbesondere mit wenigstens einer Datenleitung und/oder wenigstens einer Signalleitung verbunden sein, über welche die gegebenenfalls zur Bestimmung der Arbeitspunktinformation herangezogenen Messgrößen und/oder Informationen übermittelt werden.

Weiterhin kann erfindungsgemäß vorgesehen sein, dass Pulswechselrichter verwendet werden, deren jeweils zugeordnete Treiber zusammen mit dem Phasenregler als gemeinsame Schaltung, insbesondere als ein Mikrocontroller, realisiert sind, oder dass wenigstens ein Pulswechselrichter verwendet wird, dessen zugeordneter Treiber mit einem als weitere Schaltung ausgebildeten Phasenregler über eine Signalleitung und/oder eine Datenkommunikationsleitung verbunden sind. Pulswechselrichter, deren jeweils zugeordnete Treiber zusammen mit dem Phasenregler als eine gemeinsame Schaltung ausgebildet sind, können beispielsweise auch in demselben Gehäuse, das heißt in direkt räumlicher Nähe zueinander, angeordnet sein. Die wenigstens zwei Pulswechselrichter können dabei als ein Doppelinverter oder ein Mehrfachinverter mit einem gemeinsamen Steuergerät ausgebildet sein, wobei das Steuergerät sowohl die den Pulswechselrichtern zugeordneten Treiber als auch den Phasenregler umfassen kann.

Es ist jedoch auch möglich, Pulswechselrichter zu verwenden, welche beabstandet voneinander, beispielsweise an verschiedenen Orten innerhalb eines Kraftfahrzeuges, angeordnet sind, wobei wenigstens ein Pulswechselrichter verwendet wird, dessen zugeordneter Treiber mit einem als weitere Schaltung ausgebildeten Phasenregler über eine Signalleitung und/oder eine Datenkommunikationsleitung verbunden ist, so dass der Phasenregler bei dem zugeordneten Treiber des wenigstens einen Pulswechselrichters durch Anpassung des Ansteuersignals eine Phasendifferenz einstellen kann. Die Datenkommunikationsleitung kann dabei beispielsweise als Datenbus oder Digitalleitung ausgeführt sein. Es kann auch eine zur Übertragung eines elektrischen Signals ausgebildete Signalleitung verwendet werden. Es ist möglich, dass der oder die Treiber des wenigstens einen Pulswechselrichters, welche mit dem Phasenregler verbunden sind, auf derselben Platine wie der Phasenregler angeordnet sind oder dass die beabstandet dazu und über beispielsweise als Leitungen, Flachbandkabel oder Ähnliches als Signalleitung und/oder Datenkommunikationsleitung verbunden sind.

Erfindungsgemäß kann vorgesehen sein, dass Pulswechselrichter mit 2-Level-Topologie und/oder Pulswechselrichter mit Multilevel-Topologie verwendet werden und/oder dass Pulswechselrichter mit drei Phasen verwendet werden und/oder dass Pulswechselrichter mit mehr als drei Phasen verwendet werden. Es ist möglich, dass die wenigstens zwei mit dem Gleichstromnetzwerk verbundenen Pulswechselrichter jeweils dieselbe Topologie und/oder dieselbe Anzahl an Phasen aufweisen oder dass als wenigstens zwei Pulswechselrichter unterschiedliche Pulswechselrichter, das heißt Pulswechselrichter mit unterschiedlicher Topologie und/oder einer unterschiedlichen Anzahl an Phasen, verwendet werden.

In einer bevorzugten Ausgestaltung der Erfindung kann vorgesehen sein, dass Pulswechselrichter mit Halbleiterschaltern, insbesondere mit MOSFETs, IGBTs und/oder Dioden, verwendet werden. Auch der Einsatz von anderen Arten von Halbleiterbauelementen und/oder einer Kombination von anderen Halbleiterbauelementen und MOSFETs, IGBTs und/oder Dioden ist für die wenigstens zwei Pulswechselrichter denkbar.

Erfindungsgemäß kann vorgesehen sein, dass ein Gleichstromnetzwerk mit einer Spannung zwischen 40V und 1200V verwendet wird und/oder dass ein Gleichstromnetzwerk mit einem Kondensator, insbesondere einem Folienkondensator, Keramikkondensator oder einem Elektrolytkondensator, verwendet wird. Insbesondere kann vorgesehen sein, dass ein Gleichstromnetzwerk mit genau einem Kondensator verwendet wird. Der Kondensator kann dabei im Gleichstromnetzwerk parallel zu den Gleichspannungsanschlüssen der wenigstens zwei Pulswechselrichter angeordnet sein. Insbesondere bei in räumlicher Nähe oder in einem gemeinsamen Gehäuse angeordneten wenigstens zwei Pulswechselrichtern kann der Einsatz von genau einem Kondensator zu einer Ersparnis von Kosten und/oder Bauraum führen und ist vorteilhaft aufgrund der bereits durch die arbeitspunktabhängige Phasendifferenz reduzierten Störungen im Gleichstromnetzwerk möglich, welche die insgesamt benötigte Kapazität reduzieren.

Für eine erfindungsgemäße Schaltungsanordnung ist vorgesehen, dass sie ein Gleichstromnetzwerk sowie wenigstens zwei mit dem Gleichstromnetzwerk verbundene, jeweils über ein Ansteuersignal ansteuerbare und jeweils in einem Arbeitspunkt betreibbare Pulswechselrichter umfasst, wobei die Schaltungsanordnung ein Steuergerät umfasst, welches zur Durchführung eines erfindungsgemäßen Verfahrens ausgebildet ist.

Die wenigstens zwei Pulswechselrichter können dabei insbesondere parallel zueinander in dem Gleichstromnetzwerk geschaltet sein.

Erfindungsgemäß kann vorgesehen sein, dass jedem Pulswechselrichter ein Treiber der Schaltungsanordnung zugeordnet ist, durch welchen der Pulswechselrichter mit dem Ansteuersignal ansteuerbar ist, wobei wenigstens einer der Treiber durch eine die Arbeitspunktinformation auswertenden Phasenregler des Steuergeräts zur Ausbildung der Phasendifferenz ansteuerbar ist.

Weiterhin kann erfindungsgemäß vorgesehen sein, dass die Treiber zusammen mit dem Phasenregler als eine gemeinsame Schaltung, insbesondere als ein Mikrocontroller, realisiert sind, oder dass der oder die Treiber wenigstens eines der Pulswechselrichter mit einem als weitere Schaltung ausgebildeten Phasenregler über eine Signalleitung und/oder eine Datenkommunikationsleitung verbunden sind.

Sämtliche in Bezug zu dem erfindungsgemäßen Verfahren beschriebenen Vorteile und Ausgestaltung gelten entsprechend auch für die erfindungsgemäße Schaltungsanordnung.

Für ein erfindungsgemäßes Kraftfahrzeug ist vorgesehen, dass es eine erfindungsgemäße Schaltungsanordnung umfasst.

Die Schaltungsanordnung kann dabei insbesondere zum Betrieb von zwei oder mehr Elektromaschinen in dem Kraftfahrzeug dienen. Bei den Elektromaschinen kann es sich beispielsweise um elektrische Traktionsmotoren und/oder um Antriebsmotoren von elektrischen Verdichtern oder Ähnlichem handeln. Bei den Traktionsmotoren ist es möglich, dass das Kraftfahrzeug beispielsweise zwei, drei oder vier Traktionsmotoren umfasst. Ein zwei Traktionsmotoren umfassendes Kraftfahrzeug kann beispielsweise zwei jeweils mit einem Rad oder einer Achse gekoppelte Traktionsmotoren aufweisen. Ein Kraftfahrzeug mit drei Traktionsmotoren kann beispielsweise eine mit einer Vorderachse des Kraftfahrzeugs gekoppelte Elektromaschine sowie zwei jeweils mit einem Hinterrad des Kraftfahrzeugs gekoppelte Elektromaschinen umfassen. Bei einem vier Traktionsmotoren umfassenden Kraftfahrzeug kann vorgesehen sein, dass dieses vier als Radnabenmotoren ausgeführte Elektromaschinen aufweist.

Die Traktionsmotoren des Kraftfahrzeuges können jeweils über einen eigenen Pulswechselrichter betrieben werden, wobei die zum Betrieb der Traktionsmotoren notwendige Energie in einem Energiespeicher des Kraftfahrzeuges, beispielsweise in einer Hochvoltbatterie oder einem Brennstoffzellensystem des Kraftfahrzeuges, gespeichert ist. Der Energiespeicher kann über das Gleichstromnetzwerk mit dem Pulswechselrichtern verbunden sein. In dem Gleichstromnetzwerk können weitere mit Gleichstrom betriebene Komponenten des Kraftfahrzeuges vorgesehen sein. Das Gleichstromnetzwerk des Kraftfahrzeuges kann dabei insbesondere ein Hochvoltgleichstromnetzwerk sein, welches mit einer Spannung zwischen 40V und 1200V betrieben wird.

Sämtliche in Bezug zu dem erfindungsgemäßen Verfahren bzw. zu der erfindungsgemäßen Schaltungsanordnung beschriebenen Vorteile und Ausgestaltungen gelten entsprechend auch für das erfindungsgemäße Kraftfahrzeug.

Weitere Vorteile und Einzelheiten der Erfindung ergeben sich aus den nachfolgend beschriebenen Ausführungsbeispielen sowie anhand der Zeichnungen. Diese sind schematische Darstellungen und zeigen:
- Fig. 1: eine Aufsicht auf ein erfindungsgemäßes Kraftfahrzeug,
- Fig. 2: eine erfindungsgemäße Schaltungsanordnung,
- Fig. 3: ein Diagramm der Phasenströme zweier Pulswechselrichter, und
- Fig. 4: ein Flussdiagramm eines erfindungsgemäßen Verfahrens.

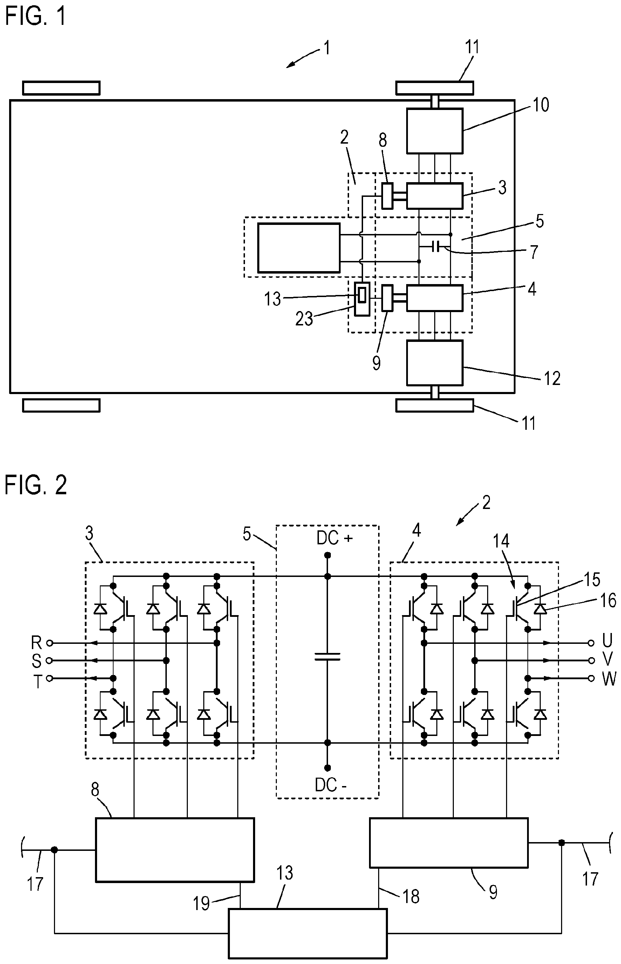

In Fig. 1 ist eine schematische Aufsicht auf ein erfindungsgemäßes Kraftfahrzeug 1 dargestellt. Das Kraftfahrzeug 1 umfasst eine Schaltungsanordnung 2, welche zwei Pulswechselrichter 3, 4 umfasst. Die Pulswechselrichter 3, 4 sind mit einem Gleichstromnetzwerk 5 verbunden. In dem Gleichstromnetzwerk 5 sind die Pulswechselrichter 3, 4 parallel zur einem Energiespeicher 6 sowie einem Kondensator 7 geschaltet.

Den Pulswechselrichtern 3, 4 ist jeweils ein Treiber 8 bzw. 9 zugeordnet, über welche der jeweilige Pulswechselrichter 3, 4 mit einem Ansteuersignal angesteuert werden kann. Der Pulswechselrichter 3 ist mit einer elektrischen Maschine 10 verbunden, welche mit einem Rad 11 des Kraftfahrzeuges 1 mechanisch gekoppelt ist. Entsprechend ist der Pulswechselrichter 4 mit einer elektrischen Maschine 12 verbunden, welche ebenfalls mit einem Rad 11 des Kraftfahrzeuges 1 mechanisch gekoppelt ist. Die Pulswechselrichter 3, 4 dienen dazu, die über das Gleichstromnetzwerk 5 aus dem Energiespeicher 6 entnehmbare elektrische Energie in einen Wechselstrom zum Betrieb der elektrischen Maschinen 10, 12 zu wandeln. Über die elektrischen Maschinen 10, 12 können die Räder 11 des Kraftfahrzeuges 1 angetrieben und das Kraftfahrzeug 1 bewegt werden. Umgekehrt kann in einem Generatorbetrieb der elektrischen Maschinen 10, 12 von diesen erzeugter Wechselstrom durch die Pulswechselrichter 3, 4 in einen Gleichstrom zum Laden des Energiespeichers 6 umgewandelt werden. Der Energiespeicher 6 kann als Hochvoltbatterie oder als Brennstoffzellensystem ausgeführt sein. Die Spannung des Gleichstromnetzwerks 5 kann beispielsweise zwischen 40V und 1200V betragen.

Die Schaltungsanordnung 2 umfasst weiterhin ein Steuergerät 23, welches einen Phasenregler 13 aufweist. Über den Phasenregler des Steuergerätes 23 können die Treiber 8, 9 der Pulswechselrichter 3, 4 zu einer Anpassung ihres jeweiligen, den zugeordneten Pulswechselrichter 3 oder 4 ansteuernden Ansteuersignals angesteuert werden. Bei Betrieb des Kraftfahrzeuges 1 können sich fortlaufend unterschiedliche Arbeitspunkte der Pulswechselrichter 3, 4 ergeben. Diese Arbeitspunkte richten sich beispielsweise nach dem fahrsituationsabhängigen Betrieb der elektrischen Maschinen 10, 12. Aufgrund der betriebsbedingten Schaltvorgänge der Pulswechselrichter 3, 4 in ihren jeweiligen Arbeitspunkten können im Gleichstromnetzwerk 5 Störungen auftreten. Diese Störungen können als ein den Gleichstrom bzw. die Gleichspannung im Gleichstromnetzwerk 5 überlagernder Wechselstrom bzw. Wechselspannung aufgefasst werden.

Um die Auswirkungen dieser Störungen auf weitere Komponenten des Gleichstromnetzwerks 5, beispielsweise auf den Energiespeicher 6, zu reduzieren, ist der Kondensator 7 vorgesehen, über welchen eine Glättung der Störungen erreicht werden kann. Weiterhin wird eine Reduktion dieser Störungen dadurch erreicht, dass über den Phasenregler des Steuergerätes 13 eine von den Arbeitspunkten der Pulswechselrichter 3, 4 abhängige Phasendifferenz zwischen den Ansteuersignalen der wenigstens zwei Pulswechselrichter 3, 4 eingestellt wird. Dies ermöglicht es, den Kondensator 7 kleiner, das heißt mit geringer Kapazität auszuführen, da durch ihn nur bereits verringerte Störungen im Gleichstromnetzwerk 5 kompensiert werden müssen. Der Kondensator 7 kann als Folienkondensator, als Keramikkondensator oder als Elektrolytkondensator ausgeführt sein.

In Fig. 2 ist die Schaltungsanordnung 2 dargestellt. Die Pulswechselrichter 3, 4 umfassen hierbei sechs Halbleiterschalter 14, welche jeweils einen als MOSFET oder IGBT ausgeführten Transistor 15 sowie eine Halbleiterdiode 16 aufweisen. Durch das Schalten der Halbleiterschalter 14 kann der über den mit den Kontakten DC+ bzw. DC- des Gleichstromnetzwerks 5 verbundenen Energiespeicher 6 bereitgestellte Gleichstrom wechselgerichtet werden, beispielsweise um die in Bezug zur Fig. 1 dargestellten elektrischen Maschine 10, 12 zu betreiben. Die dargestellten Pulswechselrichter 3, 4 wandeln den Gleichstrom des Gleichstromnetzwerks 5 in einen dreiphasigen Wechselstrom. Die drei Phasen des Pulswechselrichters 3 werden mit R, S und T bezeichnet. Die drei Phasen des Wechselrichters 4 werden entsprechend mit U, V und W bezeichnet.

Die Halbleiterschalter 14 der Pulswechselrichter 3 bzw. 4 sind jeweils mit dem zugeordneten Treiber 8 bzw. 9 verbunden, wobei die Schaltvorgänge der Halbleiterschalter 14 durch von den Treibern 8, 9 erzeugte Ansteuersignale geschaltet werden. Die Arbeitspunkte der Pulswechselrichter 3, 4 ergeben sich abhängig von dem einzustellenden Betriebszustand der über die Pulswechselrichter 3, 4 betriebenen Lasten, wie beispielsweise der vorangehenden Bezug zur Fig. 1 beschriebenen Elektromaschinen 10, 12.

Abhängig von der Kombination der Arbeitspunkte der Pulswechselrichter 3, 4 können, wie vorangehend beschrieben, unerwünschte Störungen im Gleichstromnetzwerk 5 auftreten. Zur Vermeidung dieser Störungen wird von dem Phasenregler 13 in Abhängigkeit einer die Arbeitspunkte der Pulswechselrichter 3, 4 beschreibenden Arbeitspunktinformation eine Phasendifferenz ermittelt, welche anschließend durch Anpassung wenigstens eines Ansteuersignals eines der Treiber 8, 9 eingestellt wird.

Die Arbeitszeitpunktinformation kann dabei von dem Phasenregler 13 in Abhängigkeit von durch die Pulswechselrichter 3, 4 erzeugten Wechselströmen ermittelt werden. Dabei kann die Amplitude, die Frequenz und/oder der zeitliche Verlauf eines jeweils über die Phasen R, S und T bzw. U, V und W erzeugten Wechselstromes betrachtet werden. Es ist auch möglich, dass die Arbeitspunktinformation in Abhängigkeit der durch die Pulswechselrichter 3, 4 erzeugten Phasenströme ermittelt wird, wobei beispielsweise die Amplitude, die zeitliche Dauer und/oder der zeitliche Verlauf der jeweiligen Phasenströme der Phasen R, S und T sowie U, V und W betrachtet werden kann. Zur Bestimmung der von den Pulswechselrichtern 3, 4 jeweils erzeugten Wechselströme bzw. zur Bestimmung der von den Pulswechselrichtern 3, 4 erzeugten Phasenströme ist der Phasenregler 13 mit an den Phasen R, S, T sowie U, V, W angeordneten Stromsensoren (hier nicht dargestellt) verbunden.

Zusätzlich oder alternativ dazu kann der Phasenregler 13 die Arbeitspunktinformation in Abhängigkeit wenigstens einer Messgröße des Gleichstromnetzwerks 5 ermitteln. Als Messgröße des Gleichstromnetzwerks 5 kann ein Gleichstrom und/oder eine Gleichspannung des Gleichstromnetzwerks 5 verwendet werden. Dazu kann der Phasenregler 3 mit einem oder mehreren Sensoren (hier nicht dargestellt) verbunden sein, welche einen Gleichstrom und/oder eine Gleichspannung im Gleichstromnetzwerk 5 messen.

Zusätzlich oder alternativ zu einer Messung der Messgröße im Gleichstromnetzwerk und/oder der Messung der Wechselströme bzw. der Phasenströme ist es auch möglich, dass Parameter zur Bestimmung der Arbeitspunktinformation über eine als Datenbus 17 ausgebildete Datenkommunikationsleitung an den Phasenregler 13 übermittelt werden. Die Treiber 8, 9 der Pulswechselrichter 3, 4 sind mit dem Datenbus 17 verbunden, über welchen Parameter des von den Pulswechselrichtern 3, 4 einzustellenden Arbeitspunkts an die Treiber 8, 9 übermittelt werden. In Bezug zu den vorangehend beschriebenen Elektromaschinen 10, 12 können dies beispielsweise die durch die jeweiligen elektrischen Maschinen 10, 12 zu erzeugenden Sollmomente und/oder die von den jeweiligen elektrischen Maschinen 10, 12 zu erzeugenden Solldrehzahlen sein. Die Arbeitspunktinformation kann von dem Phasenregler 13 in Abhängigkeit dieser Sollmomente und/oder dieser Solldrehzahlen ermittelt werden. Zusätzlich oder alternativ dazu können auch über die Datenkommunikationsleitung 17 übermittelte Rotorlageinformationen, welche jeweils eine Lage eines Rotors der jeweiligen elektrischen Maschinen 10, 12 beschreiben, berücksichtigt werden.

Der Phasenregler 13 kann auf Grundlage der erhaltenen Parameter und/oder Informationen und/oder der erhaltenen Messwerte eine die Arbeitspunkte der Pulswechselrichter 3, 4 beschreibende Arbeitspunktinformation bestimmen. Abhängig von der Arbeitspunktinformation, also abhängig von den jeweils eingestellten Arbeitspunkten der Pulswechselrichter 3, 4, ermittelt der Phasenregler 13 eine Phasendifferenz. Diese Phasendifferenz kann aus einer Zuordnungsvorschrift, welche in einer Speichereinheit des Phasenreglers 13 gespeichert ist, ermittelt werden. Zusätzlich oder alternativ dazu kann die Phasendifferenz in Abhängigkeit einer Messgröße des Gleichstromnetzwerks 5, wie eines im Gleichstromnetzwerk 5 gemessenen Stromes und/oder einer im Gleichstromnetzwerk 5 gemessenen Spannung, ermittelt werden. Die Ermittlung der Phasendifferenz durch den Phasenregler 13 erfolgt dabei derart, dass eine dem Gleichstromnetzwerk 5 auftretender Wechselstrom und/oder eine in dem Gleichstromnetzwerk 5 auftretende Wechselspannung minimiert wird.

Die Phasendifferenz wird dadurch eingestellt, dass durch den Phasenregler 13 über eine Signalleitung 18 der Treiber 9 des Pulswechselrichters 4 zur Anpassung des von dem Treiber 9 erfolgten Ansteuersignals angesteuert wird. Der über eine Signalleitung 19 mit dem Phasenregler 13 verbundene Treiber 8 wird nicht angesteuert, das heißt, das Ansteuersignal des Treibers 8 wird ohne Änderung an den Pulswechselrichter 3 übertragen. Alternativ kann die Phasendifferenz auch eingestellt werden, in dem beide Treiber 8, 9 angesteuert werden.

Beispielsweise ist es bei einem Wert der Phasendifferenz von 30° möglich, einen der Treiber 8, 9 derart anzusteuern, dass eine Periode der über das Ansteuersignal erzeugten Taktung des zugeordneten Pulswechselrichters 3, 4 derart verlängert wird, dass sich eine Phasendifferenz von 30° einstellt. Eine Phasendifferenz kann jedoch auch dadurch eingestellt werden, dass beide Treiber 8, 9 derart angesteuert werden, dass sich insgesamt eine Phasendifferenz von 30° ergibt, zum Beispiel in dem eine Periode einer Taktung eines der Pulswechselrichters 3, 4 derart verkürzt wird, dass sich ein Phasenversatz von +15° einstellt und eine Periode der Taktung des anderen Pulswechselrichters 3, 4 derart verlängert wird, dass sich ein Phasenversatz von -15° ergibt.

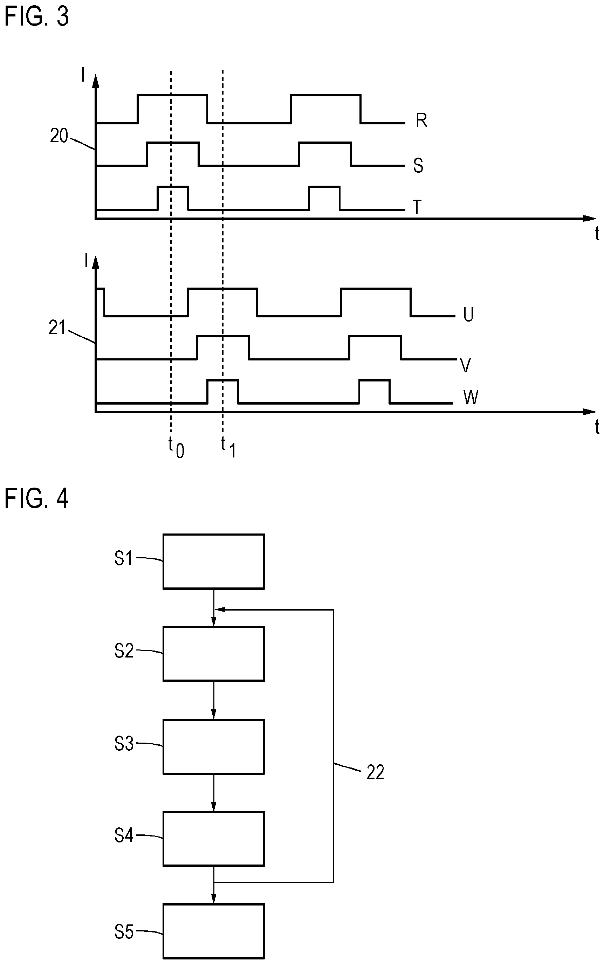

In Fig. 3 ist ein Diagramm der Phasenströme der Pulswechselrichter 3, 4 dargestellt. Im oberen Teil 20 des Diagramms sind die Phasenströme der Phasen R, S, T des Pulswechselrichters 3 dargestellt. Im unteren Teil 21 des Diagramms sind die Phasenströme der Phasen U, V, W des Pulswechselrichters 4 aufgetragen. Zum Zeitpunkt to wird eine Phasendifferenz erzeugt. Dazu wird das Ansteuersignal, welches vom Treiber 9 erzeugt wird, derart angepasst, dass eine Periode der Taktung des Pulswechselrichters 4 verlängert wird. Die zum Zeitpunkt to gleichphasig mit den Phasenströmen des Pulswechselrichters 3 erzeugten Phasenströme des Pulswechselrichters 4 werden durch die Verlängerung der Periode der Taktung des Pulswechselrichters 4 auf den Zeitpunkt t₁ verschoben. Ersichtlich bildet sich zwischen den Taktungen der vormals gleichphasig betriebenen Pulswechselrichter 3, 4 eine Phasendifferenz aus, welche sich auch entsprechend im zeitlichen Verlauf der Phasenströme niederschlägt.

Der in den Teilen 20, 21 des Diagrammes gezeigte Verlauf des Phasenstroms ist rein beispielhaft. Es ist insbesondere auch möglich, dass der Phasenversatz durch eine Verkürzung der Periode der Taktung eines der Pulswechselrichter 3, 4 erzeugt wird. Es ist auch möglich, dass beide Pulswechselrichter 3, 4 zur Erzeugung der Phasendifferenz angesteuert werden, wobei beispielsweise die Taktung eines der Pulswechselrichter 3, 4 verkürzt und die Taktung des anderen Pulswechselrichters 3, 4 verlängert wird, so dass sich insgesamt die von dem Phasenregler 13 ermittelte Phasendifferenz einstellt. Weiterhin kann eine Phasendifferenz auch eingestellt werden, ohne das ein gleichphasiger Betrieb der Pulswechselrichter 3, 4 vorliegt. Insbesondere ist es auch möglich, dass die Pulswechselrichter 3, 4 unterschiedliche Taktfrequenzen aufweisen.

Die Treiber 8, 9 sowie der Phasenregler 13 können als eine gemeinsame Schaltung, beispielsweise als Mikrocontroller, realisiert sein. Diese Schaltung kann mit den Pulswechselrichtern 3, 4 in einem gemeinsamen Gehäuse untergebracht sein. Es ist auch möglich, dass der Phasenregler 13 nur mit einem der Treiber 8, 9 als gemeinsame Schaltung realisiert ist, wobei der andere der Treiber 8, 9 über eine beispielsweise als Leiterbahn einer Platine oder als ein Kabel ausgebildete Signalleitung 18 bzw. 19 mit dem Phasenregler verbunden ist. Der Phasenregler 13 kann auch als eigenständige Schaltung, beispielsweise als ein Steuergerät ausgebildet sein, und mit den Treibern 8, 9 über jeweils eine als Leiterbahn oder als Kabel ausgebildete Signalleitung 18, 19 verbunden sein. Die Signalleitungen 18, 19 können auch als Datenkommunikationsverbindung, beispielsweise als Datenbus, ausgeführt sein.

In Fig. 4 ist ein Flussdiagramm eines erfindungsgemäßen Verfahrens dargestellt. In Schritt S1 erfolgt der Start des Verfahrens. In Schritt S2 wird durch den Phasenregler 13 wie vorangehend beschrieben eine Arbeitspunktinformation ermittelt, welche die jeweiligen Arbeitspunkte der Pulswechselrichter beschreibt. Anschließend wird in Schritt S3 wie vorangehend beschrieben durch den Phasenregler 13 in Abhängigkeit der ermittelten Arbeitspunktinformation eine Phasendifferenz ermittelt. In Schritt S4 erfolgt die Anpassung des Ansteuersignals wenigstens eines der Pulswechselrichter 3, 4 zur Erzeugung der Phasendifferenz zwischen den Pulswechselrichtern 3, 4. Anschließend kann, wie durch den Pfeil 22 angedeutet ist, eine erneute Ermittlung einer Arbeitspunktinformation durch den Phasenregler 13 erfolgen.

Dadurch kann auf einen geänderten Arbeitspunkt wenigstens eines der Pulswechselrichter 3, 4 reagiert werden, so dass eine erneute Phasendifferenz ermittelt und eine entsprechende Anpassung des Ansteuersignals wenigstens eines der Pulswechselrichter 3, 4 vorgenommen werden kann. In Schritt S5 endet das Verfahren.

Neben den vorangehend beschriebenen Ausführungen mit zwei Pulswechselrichtern 3, 4 ist es auch möglich, dass mehr als zwei Pulswechselrichter 3, 4 verwendet werden. Auch im Falle von mehr als zwei Pulswechselrichtern 3, 4 kann eine Phasendifferenz durch Anpassung des Ansteuersignals eines oder mehrerer der Pulswechselrichter 3, 4 erzeugt werden. Es ist insbesondere möglich, dass Pulswechselrichter 3, 4 mit 2-Level-Topologie und/oder Pulswechselrichter 3, 4 mit Multilevel-Topologie verwendet werden und/oder dass Pulswechselrichter 3, 4 mit drei Phasen verwendet werden und/oder dass Pulswechselrichter 3, 4 mit mehr als drei Phasen verwendet werden. Es ist möglich, dass die wenigstens zwei mit dem Gleichstromnetzwerk 5 verbundenen Pulswechselrichter 3,4 jeweils dieselbe Topologie und/oder dieselbe Anzahl an Phasen aufweisen oder dass unterschiedliche Pulswechselrichter 3, 4, das heißt Pulswechselrichter 3, 4 mit unterschiedlicher Topologie und/oder einer unterschiedlichen Anzahl an Phasen, verwendet werden.

## Patentansprüche

1. Verfahren zum Betrieb von wenigstens zwei mit einem Gleichstromnetzwerk (5) verbundenen Pulswechselrichtern (3, 4), wobei die Pulswechselrichter (3, 4) jeweils über ein Ansteuersignal angesteuert und in jeweils einem Arbeitspunkt betrieben werden,
**dadurch gekennzeichnet,**
**dass** in Abhängigkeit einer die Arbeitspunkte der Pulswechselrichter (3, 4) beschreibenden Arbeitspunktinformation eine Phasendifferenz zwischen den Ansteuersignalen der wenigstens zwei Pulswechselrichter (3, 4) durch Anpassung des Ansteuersignals wenigstens eines der Pulswechselrichter (3, 4) erzeugt wird.

2. Verfahren nach Anspruch 1,
**dadurch gekennzeichnet,**
**dass** die Phasendifferenz derart eingestellt wird, dass ein in dem Gleichstromnetzwerk (5) auftretender Wechselstrom und/oder eine in dem Gleichstromnetzwerk (5) auftretende Wechselspannung minimiert wird.

3. Verfahren nach Anspruch 1 oder 2,
**dadurch gekennzeichnet,**
**dass** ein Wert der Phasendifferenz in Abhängigkeit einer Messgröße des Gleichstromnetzwerks (5), insbesondere eines im Gleichstromnetzwerk (5) gemessenen Stromes und/oder einer im Gleichstromnetzwerk (5) gemessenen Spannung, und/oder anhand einer hinterlegten Zuordnungsvorschrift ermittelt wird.

4. Verfahren nach einem der vorangehenden Ansprüche,
**dadurch gekennzeichnet,**
**dass** die Arbeitspunktinformation in Abhängigkeit von durch die Pulswechselrichter (3, 4) jeweils erzeugten Wechselströmen, insbesondere von durch die Pulswechselrichter (3, 4) jeweils erzeugten Phasenströmen, ermittelt wird.

5. Verfahren nach einem der vorangehenden Ansprüche,
**dadurch gekennzeichnet,**
**dass** die Arbeitspunktinformation in Abhängigkeit wenigstens einer Messgröße des Gleichstromnetzwerks (5), insbesondere eines Gleichstromes und/oder einer Gleichspannung des Gleichstromnetzwerks (5), ermittelt wird.

6. Verfahren nach einem der vorangehenden Ansprüche,
**dadurch gekennzeichnet,**
**dass** die Pulswechselrichter (3, 4) jeweils mit einer elektrischen Maschine (10, 12) verbunden sind, wobei die Arbeitspunktinformation in Abhängigkeit von durch die jeweiligen elektrischen Maschinen (10, 12) zu erzeugenden Sollmomenten und/oder von durch die jeweiligen elektrischen Maschinen zu erzeugenden Solldrehzahlen und/oder von jeweils eine Lage eines Rotors der jeweiligen elektrischen Maschine (10, 12) beschreibenden Rotorlageinformationen ermittelt wird.

7. Verfahren nach einem der vorangehenden Ansprüche,
**dadurch gekennzeichnet,**
**dass** der wenigstens eine Pulswechselrichter (3, 4) zur Ausbildung der Phasendifferenz derart angesteuert wird, dass wenigstens eine Periode seiner Taktung verlängert oder verkürzt wird.

8. Verfahren nach einem der vorangehenden Ansprüche,
**dadurch gekennzeichnet,**
**dass** zur Ausbildung der Phasendifferenz einer der Pulswechselrichter (3, 4) unverändert weiterbetrieben wird, wobei der oder die weiteren Pulswechselrichter (3, 4) zur Ausbildung der Phasendifferenz angesteuert werden oder dass alle Pulswechselrichter zur Ausbildung der Phasendifferenz angesteuert werden.

9. Verfahren nach einem der vorangehenden Ansprüche,
**dadurch gekennzeichnet,**
**dass** jedem Pulswechselrichter (3, 4) ein Treiber (8, 9) zugeordnet ist, durch welchen der Pulswechselrichter (3, 4) mit dem Ansteuersignal angesteuert wird, wobei wenigstens einer der Treiber durch einen die Arbeitspunktinformation auswertenden Phasenregler (13) zur Ausbildung der Phasendifferenz angesteuert wird.

10. Verfahren nach Anspruch 9,
**dadurch gekennzeichnet,**
**dass** Pulswechselrichter (3, 4) verwendet werden, deren jeweils zugeordnete Treiber (8, 9) zusammen mit dem Phasenregler (13) als gemeinsame Schaltung, insbesondere als ein Mikrocontroller, realisiert sind, oder dass wenigstens ein Pulswechselrichter (3, 4) verwendet wird, dessen zugeordneter Treiber (8, 9) mit einem als weitere Schaltung ausgebildeten Phasenregler (13) über eine Signalleitung (18, 19) und/oder eine Datenkommunikationsleitung verbunden ist.

11. Verfahren nach einem der vorangehenden Ansprüche,
**dadurch gekennzeichnet,**
**dass** Pulswechselrichter (3, 4) mit 2-Level-Topologie und/oder Pulswechselrichter mit Multilevel-Topologie verwendet werden und/oder dass Pulswechselrichter (3, 4) mit drei Phasen verwendet werden und/oder dass Pulswechselrichter(3, 4) mit mehr als drei Phasen verwendet werden.

12. Verfahren nach einem der vorangehenden Ansprüche,
**dadurch gekennzeichnet,**
**dass** Pulswechselrichter (3, 4) mit Halbleiterschaltern (14), insbesondere mit MOSFETs, IGBTs und/oder Dioden, verwendet werden.

13. Verfahren nach einem der vorangehenden Ansprüche,
**dadurch gekennzeichnet,**
**dass** ein Gleichstromnetzwerk (5) mit einer Spannung zwischen 40V und 1200V verwendet wird und/oder dass ein Gleichstromwerk (5) mit einem Kondensator (7), insbesondere einem Folienkondensator, Keramikkondensator oder einem Elektrolytkondensator, verwendet wird.

14. Schaltungsanordnung umfassend ein Gleichstromnetzwerk (5) sowie wenigstens zwei mit dem Gleichstromnetzwerk (5) verbundene, jeweils über ein Ansteuersignal ansteuerbare und jeweils in einem Arbeitspunkt betreibbare Pulswechselrichter (3, 4), wobei die Schaltungsanordnung ein Steuergerät (23) umfasst, welches zur Durchführung eines Verfahrens nach einem der vorangehenden Ansprüche ausgebildet ist.

15. Schaltungsanordnung nach Anspruch 14,
**dadurch gekennzeichnet,**
**dass** jedem Pulswechselrichter (3, 4) ein Treiber (8, 9) der Schaltungsanordnung (2) zugeordnet ist, durch welchen der Pulswechselrichter (3, 4) mit dem Ansteuersignal ansteuerbar ist, wobei wenigstens einer der Treiber (8, 9) durch einen die Arbeitspunktinformation auswertenden Phasenregler (13) des Steuergeräts (23) zur Ausbildung der Phasendifferenz ansteuerbar ist.

16. Schaltungsanordnung nach Anspruch 15,
**dadurch gekennzeichnet,**
**dass** die Treiber zusammen mit dem Phasenregler (13) als gemeinsame Schaltung, insbesondere als ein Mikrocontroller, realisiert sind, oder dass der oder die Treiber wenigstens eines der Pulswechselrichter (3, 4) mit einem als weitere Schaltung ausgebildeten Phasenregler (13) über eine Signalleitung (18, 19) und/oder eine Datenkommunikationsleitung verbunden sind.

17. Kraftfahrzeug umfassend eine Schaltungsanordnung (2) nach einem der Ansprüche 14 bis 16.
